# EUROPEAN PATENT APPLICATION

(11) **EP 4 567 885 A1**
(43) Date of publication of application: **11.06.2025**
(21) Application number: 24208920.9
(22) Date of filing: 25.10.2024
(51) Int. Cl.: H01L 23/525, H01L 23/528, H10D 89/10, H01L 21/768

(54) **METHOD TO ENABLE LOGIC FOR FOCUSED ION BEAM CIRCUIT EDIT IN THE UPPERMOST ROUTING LAYERS**

(30) Priority: 07.12.2023 US 202318531736
(71) Applicant: Intel Corporation, Santa Clara, CA 95054 (US)
(72) Inventor: HACK, Paul, Portland, OR 97225 (US); GIACOBBE, John, El Dorado Hills, CA 95762 (US); RONEN, Ilan, Hadera (IL); JIMENEZ CHAVEZ, Carlos Alberto, El Dorado Hills, CA 95762 (US)
(74) Representative: Viering, Jentschura & Partner mbB Patent- und Rechtsanwälte

(57) **Abstract**

According to various examples, a semiconductor device for backside power delivery is described. The semiconductor device may include a device layer including an integrated circuit, wherein the device layer is between a top metal layer and a bottom metal layer. The semiconductor device may also include a focused-ion beam access point on the top metal layer. The semiconductor device may also include one or more tie cells connected to the integrated circuit of the device layer. The semiconductor device may also include one or more functional cells connected to the one or more tie cells, wherein the one or more tie cells and one or more function cells provide an electrical route on the top metal layer to the focused-ion beam access point.

## Description

### BACKGROUND

With the introduction of backside power delivery technology, the use of conventional circuit editing using the focused-ion-beam (FIB) technology for post-silicon debug activities is severely constrained by the introduction of the metal on both the front side and back side. Due to the distinctive way the Integrated Circuits are built and packaged, the backside metal stack restricts access to transistors and interconnections in base layers.

Therefore, there is a need to provide a backside power delivery semiconductor device that is able to be edited using FIB technology.

### BRIEF DESCRIPTION OF THE DRAWINGS

In the drawings, like reference characters generally refer to the same parts throughout the different views. The drawings are not necessarily to scale, emphasis instead generally being placed upon illustrating the principles of the present disclosure. The dimensions of the various features or elements may be arbitrarily expanded or reduced for clarity. In the following description, various aspects of the present disclosure are described with reference to the following drawings, in which:
FIG. 1 shows a cross-sectional comparison of a frontside power delivery semiconductor device and a backside power delivery semiconductor device;
FIG. 2 shows a flow chart illustrating a method of forming a semiconductor device according to an aspect of the present disclosure;
FIG. 3 shows a top view of a focused ion beam editable semiconductor device according to an aspect of the present disclosure;
FIG. 4A shows topological examples of one tie cell to many functional cells according to an aspect of the present disclosure;
FIG. 4B shows topological examples of one tie cell to one functional cell according to an aspect of the present disclosure;
FIG. 5 shows a cross sectional view of a focused ion beam editable semiconductor device according to an aspect of the present disclosure;
FIG. 6 shows an illustration of a computing device that includes a semiconductor device according to a further aspect of the present disclosure.

### DETAILED DESCRIPTION

The following detailed description refers to the accompanying drawings that show, by way of illustration, specific details, and aspects in which the present disclosure may be practiced. These aspects are described in sufficient detail to enable those skilled in the art to practice the present disclosure. Various aspects are provided for the present devices, and various aspects are provided for the methods. It will be understood that the basic properties of the devices also hold for the methods and vice versa. Other aspects may be utilized and structural, and logical changes may be made without departing from the scope of the present disclosure. The various aspects are not necessarily mutually exclusive, as some aspects can be combined with one or more other aspects to form new aspects.

An advantage of the present disclosure may include less errors in the semiconductor device since the errors are able to be edited using FIB technology. Further, post-silicon process and product debug accelerates the validation of a FAB process node and the associated IC products which leads to faster market release of products and greater revenue.

These and other aforementioned advantages and features of the aspects herein disclosed will be apparent through reference to the following description and the accompanying drawings. Furthermore, it is to be understood that the features of the various aspects described herein are not mutually exclusive and can exist in various combinations and permutations.

The present disclosure generally relates to a semiconductor device for backside power delivery. The device may include a device layer including an integrated circuit, wherein the device layer is between a top metal layer and a bottom metal layer. The device may also include a focused-ion beam access point on the top metal layer. The device may also include one or more tie cells connected to the integrated circuit of the device layer. The device may also include one or more functional cells connected to the one or more tie cells, wherein the one or more tie cells and one or more function cells provide an electrical route on the top metal layer to the focused-ion beam access point.

The present disclosure generally relates to a method of forming a semiconductor device. The method may include providing a device layer including an integrated circuit, wherein the device layer is between a top metal layer and a bottom metal layer. The method may also include providing a focused-ion beam access point on the top metal layer. The method may also include connecting one or more tie cells to the integrated circuit of the device layer. The method may also include connecting one or more functional cells to the one or more tie cells, wherein the one or more tie cells and one or more function cells provide an electrical route on the top metal layer to the focused-ion beam access point.

To more readily understand and put into practical effect, the present device, method, and other particular aspects will now be described by way of examples and not limitations, and with reference to the figures. For the sake of brevity, duplicate descriptions of features and properties may be omitted.

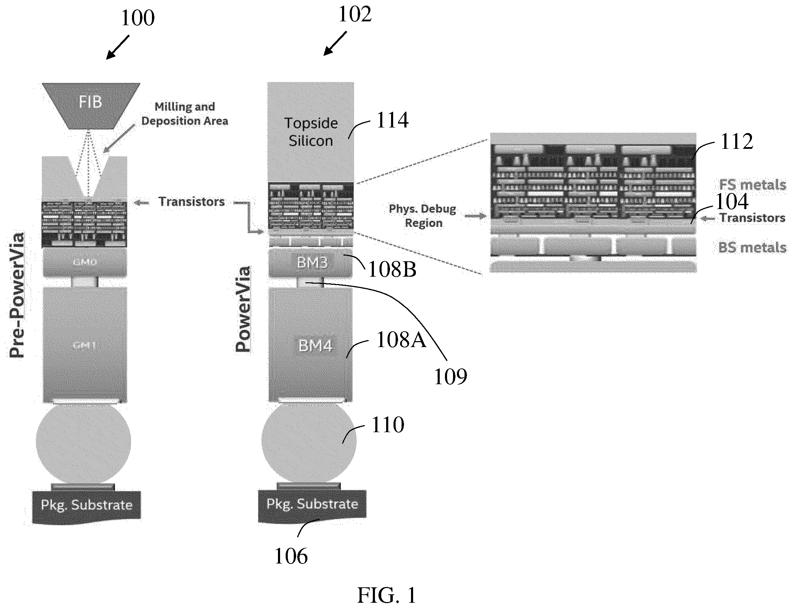

FIG. 1 shows a cross-sectional comparison of a frontside power delivery semiconductor device and a backside power delivery semiconductor device.

Device 100 is a frontside power delivery semiconductor device. For device 100, focused-ion beam (FIB) testing for post-silicon debug activities, like circuit editing may be used as milling and depositing is allowed on the front side metal stack.

Semiconductor device 102 is a backside power delivery semiconductor device. The backside power delivery technology may be Intel's PowerVia technology. With the introduction of backside power delivery technology, the use of conventional circuit editing using the focused-ion-beam (FIB) technology for post-silicon debug activities is severely constrained by the introduction of the metal on both the front side and back side. Due to the distinctive way the Integrated Circuits are built and packaged, the backside metal stack restricts access to an integrated circuit 104 in a device layer. The milling process to create access points to the devices will damage or destroy interconnections, which will result in a loss of functionality and render the part unusable for functional testing.

In an aspect of the present disclosure, the semiconductor device 102 may include a printed circuit board (PCB). The printed circuit board may be a motherboard.

In an aspect of the present disclosure, the semiconductor device 100 may include a package substrate 106. The package substrate 106 may include contact pads, electrical interconnects, routings, and other features, which are not shown in any of the present figures. The package substrate 106 may have one or more rigid core layers for improved structural stability or a coreless substrate package for a reduced form factor. In other aspects, the package substrate 106 may be part of a larger substrate that supports additional semiconductor packages, and/or components.

In an aspect of the present disclosure, the semiconductor device 102 may include the integrated circuit 104 in a device layer or a base die. In an aspect, the integrated circuit 104 may be made from any suitable semiconductor, such as silicon or gallium arsenide. The device layer may be a semiconductor die, a chip, or a set of chiplets, e.g., a system-on-chip (SOC), a platform controller hub (PCH)/chipset, a memory device, a field programmable gate array (FPGA) device, a central processing unit (CPU), or a graphic processing unit (GPU).

In an aspect of the present disclosure, the semiconductor device 102 may include one or more bottom metal layers 108A, 108B. In an aspect of the present disclosure, the semiconductor device 102 may include a via 109 to connect the one or more bottom metal layers 108A, 108B.

In an aspect of the present disclosure, the semiconductor device 100 may include a package bump 110. The package bump 110 may be disposed between the package substrate 106 and the device layer. In an aspect, the package bump 110 may facilitate an electrical connection between the device layer and the package substrate 106.

To enable FIB circuit modification capabilities, logic cells and their connections to tie cells are elevated to the uppermost front layers, allowing front metal access.

In an aspect of the present disclosure, the semiconductor device 102 may include a front side metal layer 112. In an aspect of the present disclosure, there may be a focused-ion beam access point on the front side metal layer 112.

In an aspect of the present disclosure, the semiconductor device 102 may include a topside silicon substrate 114.

In an aspect of the present disclosure, there may be one or more tie cells connected to the integrated circuit 104 of the device layer. In an aspect of the present disclosure, there may be one or more functional cells connected to the one or more tie cells, wherein the one or more tie cells and one or more function cells provide an electrical route on the top metal layer to the focused-ion beam access point.

In an aspect of the present disclosure, the electrical route on the top metal layer may be configured for focused-ion beam editing of the device layer through the focused-ion beam access point.

In an aspect of the present disclosure, a focused-ion beam device may edit errors in the integrated circuit through the focused-ion beam access point.

In an aspect of the present disclosure, the focused-ion beam device may edit errors in the integrated circuit with a focused ion beam to etch, cut or deposit material on the integrated circuit.

In an aspect of the present disclosure, TCL code for Cadence and Synopsys APR tools has been developed to insert standard logic and tie cells and elevate their inputs and outputs to the uppermost routing layers. These cells and interconnections are arranged so that the logic cell inputs are tied off using the output of the tie cells and allow appropriate access for the FIB circuit editing tools to introduce logical changes to an IC as part of the post-silicon debug process.

In an aspect of the present disclosure, standard cells and industry standard Auto-Place and Route (APR) tools may create FIB editable structures by elevating to the top-most metal layers the outputs and the connections between their inputs and the cells that provide a fixed logic level using tie cells to avoid metastability and reduce leakage, ensuring that the routing segments are long enough and spaced apart to provide clearance for FIB tools to be used for circuit editing.

In an aspect of the present disclosure, one or more functional logic cells and one or more associated tie cells are placed throughout the semiconductor device. FIB access points are created at the top-most routing layer at the top metal layer for establishing a connection point for routing the inputs and outputs of all the tie and functional cells. The tie and functional cells are placed close in valid locations and keep distance between them to assure enough room for FIB accessibility. With these constructs in place, after completing automated routing, or manually drawing the routing, the resulting structure provides access to the output ports and connections to tie cells, allowing the FIB tools to cut this connection, freeing the inputs that will be used for the editing.

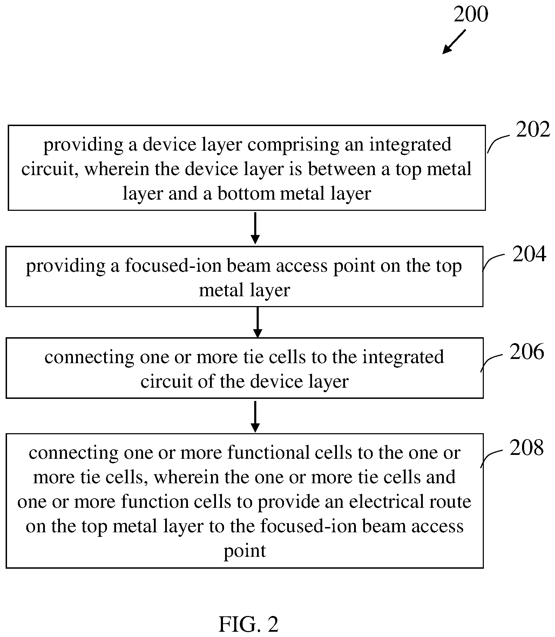

FIG. 2 shows a flow chart illustrating a method of forming a semiconductor device according to an aspect of the present disclosure.

As shown in FIG. 2, there may be a method 200 of forming a device. In the method 200, a first operation 202 may include providing a device layer including an integrated circuit, wherein the device layer is between a top metal layer and a bottom metal layer. A second operation 204 may include providing a focused-ion beam access point on the top metal layer. A third operation 206 may include connecting one or more tie cells to the integrated circuit of the device layer. A fourth operation 208 may include connecting one or more functional cells to the one or more tie cells, wherein the one or more tie cells and one or more function cells provide an electrical route on the top metal layer to the focused-ion beam access point.

It will be understood that the above operations described above relating to FIG. 2 are not limited to this particular order. Any suitable, modified order of operations may be used.

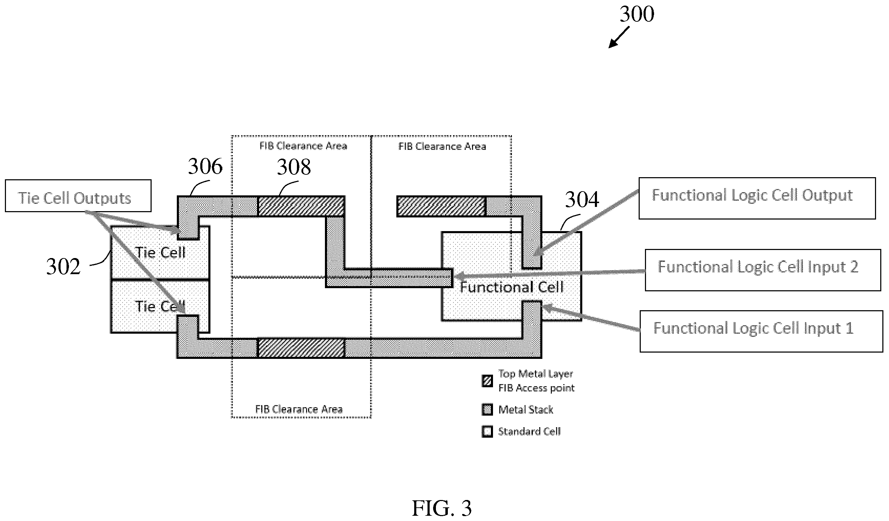

FIG. 3 shows a top view of a focused ion beam editable semiconductor device according to an aspect of the present disclosure.

In an aspect of the present disclosure, a focused ion beam editable semiconductor device 300 may include a top metal layer 306. In an aspect of the present disclosure, there may be a focused-ion beam access point 308 on the top metal layer 306.

In an aspect of the present disclosure, there may be one or more tie cells 302 connected to an integrated circuit of a device layer of the focused ion beam editable semiconductor device 300. In an aspect of the present disclosure, there may be one or more functional cells 304 connected to the one or more tie cells 302, wherein the one or more tie cells 302 and one or more function cells 304 provide an electrical route on the top metal layer 306 to the focused-ion beam access point 308.

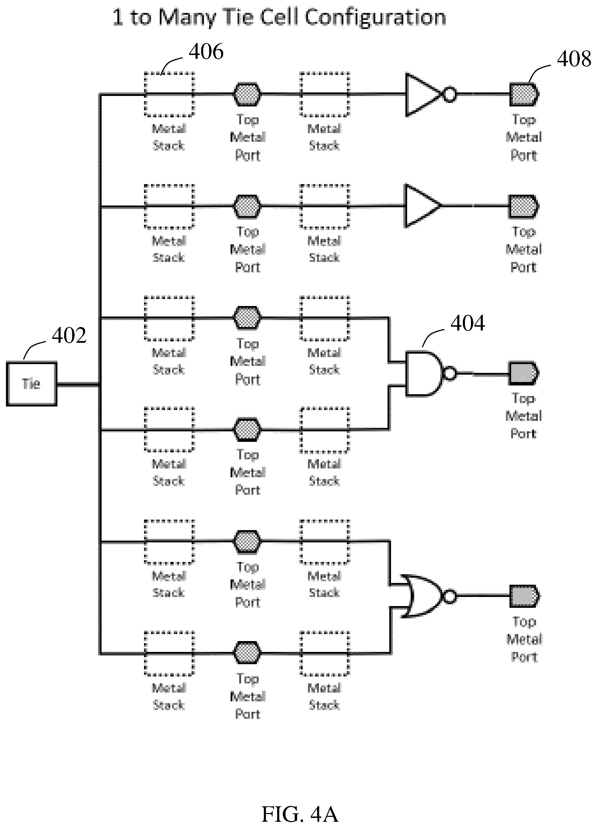

FIG. 4A shows topological examples of one tie cell to many functional cells according to an aspect of the present disclosure.

In an aspect of the present disclosure, the one or more tie cells 402 may be a single tie cell. In an aspect of the present disclosure, the one or more functional cells 404 are a plurality of functional cells. In an aspect of the present disclosure, the single tie cell is connected to the plurality of functional cells.

In an aspect of the present disclosure, there may be a top metal layer 406 and a focused-ion beam access point 408. The single tie cell and the plurality of functional cells may provide an electrical route on the top metal layer 406 to the focused-ion beam access point 408. The single tie cell may have a fixed logic level, which may be a high or low logic level. The plurality of functional cells may be one or more of a AND, OR, XOR, NOT, NAND, NOR and XNOR cell, as well as a cell resulting from their combination. The output of the cells is also connected to a focused-ion beam access point 408.

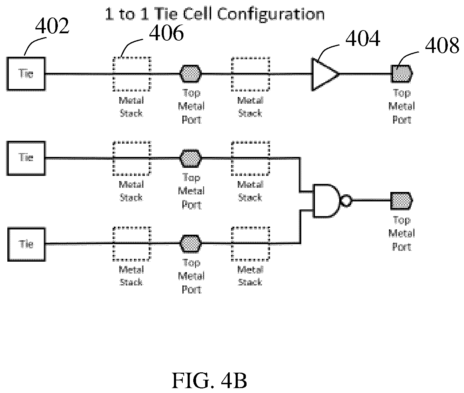

FIG. 4B shows topological examples of one tie cell to one functional cell according to an aspect of the present disclosure.

In an aspect of the present disclosure, the one or more tie cells 402 may be a single tie cell. In an aspect of the present disclosure, the one or more functional cells 404 are a single functional cell. In an aspect of the present disclosure, the single tie cell is connected to the single functional cell.

In an aspect of the present disclosure, there may be a top metal layer 406 and a focused-ion beam access point 408. The single tie cell and the the single functional cell may provide an electrical route on the top metal layer 406 to the focused-ion beam access point 408. The single tie cell may have a fixed logic level, which may be a high or low logic level. The the single functional cell may be one of a AND, OR, XOR, NOT, NAND, NOR and XNOR cell.

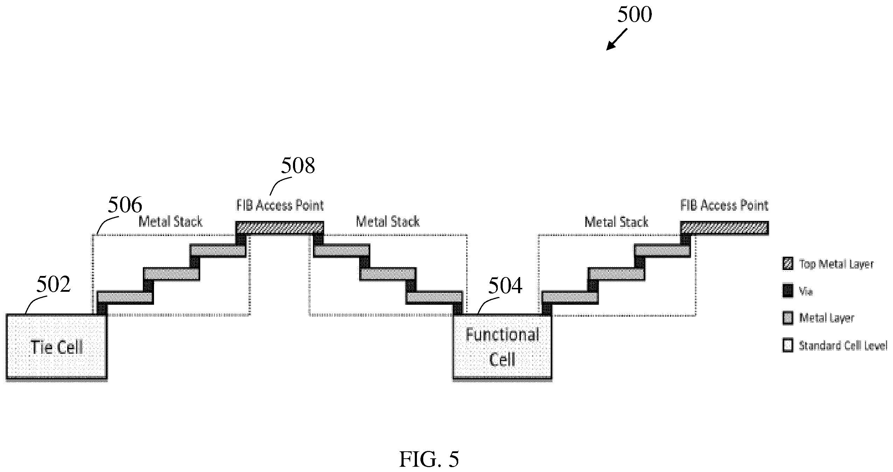

FIG. 5 shows a cross sectional view of a focused ion beam editable semiconductor device according to an aspect of the present disclosure.

In an aspect of the present disclosure, a focused ion beam editable semiconductor device 500 may include a top metal layer 506. In an aspect of the present disclosure, there may be a focused-ion beam access point 508 on the top metal layer 506.

In an aspect of the present disclosure, there may be one or more tie cells 502 connected to an integrated circuit of a device layer of the focused ion beam editable semiconductor device 500. In an aspect of the present disclosure, there may be one or more functional cells 504 connected to the one or more tie cells 502, wherein the one or more tie cells 502 and one or more function cells 502 provide an electrical route on the top metal layer 506 to the focused-ion beam access point 508.

Aspects of the present disclosure may be implemented into a system using any suitable hardware and/or software.

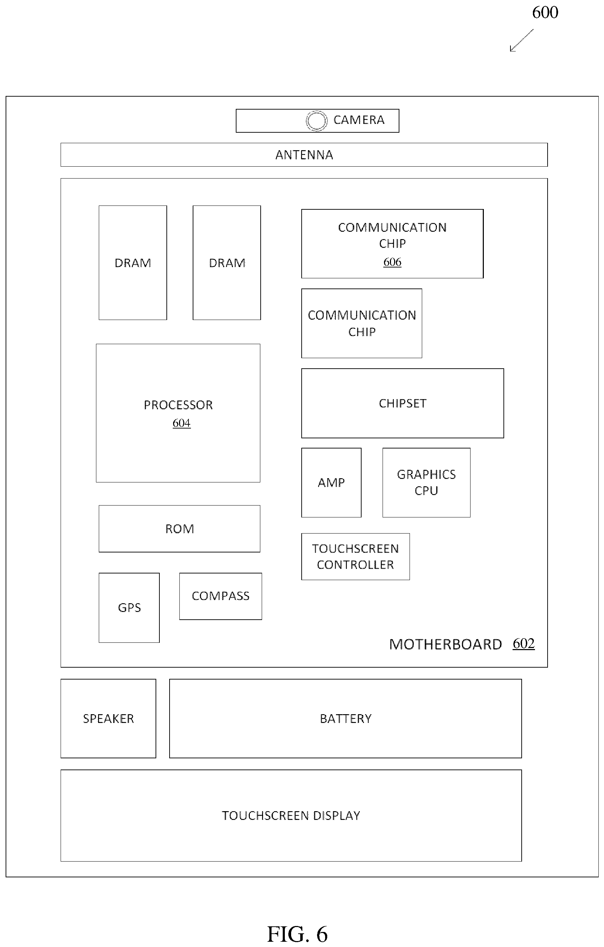

FIG. 6 schematically illustrates a computing device 600 that may include a semiconductor device as described herein, in accordance with some aspects.

As shown in FIG. 6, the computing device 600 may house a board such as a motherboard 602. The motherboard 602 may include a number of components, including but not limited to a processor 604 and at least one communication chip 606. The processor 604 may be physically and electrically coupled to the motherboard 602. In some implementations, the at least one communication chip 606 may also be physically and electrically coupled to the motherboard 402. In further implementations, the communication chip 606 may be part of the processor 604.

Depending on its applications, the computing device 600 may include other components that may or may not be physically and electrically coupled to the motherboard 602. These other components may include, but are not limited to, volatile memory (e.g., DRAM), nonvolatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, a Geiger counter, an accelerometer, a gyroscope, a speaker, a camera, and a mass storage device (such as hard disk drive, compact disk (CD), digital versatile disk (DVD), and so forth). In another aspect, the processor 604 of the computing device 600 may be packaged in a semiconductor package, as described herein, and/or other semiconductor devices may be packaged together in a semiconductor device as described herein.

The communication chip 606 may enable wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some aspects they might not. The communication chip 606 may implement any of a number of wireless standards or protocols, including but not limited to Institute for Electrical and Electronics Engineers (IEEE) standards including Wi-Fi (IEEE 502.11 family), IEEE 502.16 standards (e.g., IEEE 502.16-2005 Amendment), Long-Term Evolution (LTE) project along with any amendments, updates, and/or revisions (e.g., advanced LTE project, ultra-mobile broadband (UMB) project (also referred to as "3GPP2"), etc.). IEEE 502.16 compatible BWA networks are generally referred to as WiMAX networks, an acronym that stands for Worldwide Interoperability for Microwave Access, which is a certification mark for products that pass conformity and interoperability tests for the IEEE 502.16 standards.

The communication chip 606 may also operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 606 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 406 may operate in accordance with Code Division Multiple Access (CDMA), Time Division Multiple Access (TDMA), Digital Enhanced Cordless Telecommunications (DECT), Evolution-Data Optimized (EV-DO), derivatives thereof, as well as any other wireless protocols that are designated as 3G, 4G, 5G, and beyond. The communication chip 406 may operate in accordance with other wireless protocols in other aspects.

The computing device 600 may include a plurality of communication chips 606. For instance, a first communication chip 606 may be dedicated to shorter range wireless communications such as Wi-Fi and Bluetooth, and a second communication chip 606 may be dedicated to longer range wireless communications such as GPS, EDGE, GPRS, CDMA, WiMAX, LTE, Ev-DO, and others.

In various implementations, the computing device 600 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In an aspect, the computing device 600 may be a mobile computing device. In further implementations, the computing device 600 may be any other electronic device that processes data.

### Examples

Example 1 may include a semiconductor device for backside power delivery including a device layer including an integrated circuit, wherein the device layer is between a top metal layer and a bottom metal layer; a focused-ion beam access point on the top metal layer; one or more tie cells connected to the integrated circuit of the device layer; and one or more functional cells connected to the one or more tie cells, wherein the one or more tie cells and one or more function cells provide an electrical route on the top metal layer to the focused-ion beam access point.

Example 2 may include the device of example 1 and/or any other example disclosed herein, for which the electrical route on the top metal layer is configured for focused-ion beam editing of the device layer through the focused-ion beam access point.

Example 3 may include the device of example 1 and/or any other example disclosed herein, for which the one or more tie cells is a single tie cell, and the one or more functional cells is a plurality of functional cells, and wherein the single tie cell is connected to the plurality of functional cells.

Example 4 may include the device of example 1 and/or any other example disclosed herein, for which the one or more tie cells is a single tie cell, and the one or more functional cells is a single functional cell, and wherein the single tie cell is connected to the single functional cell.

Example 5 may include the device of example 1 and/or any other example disclosed herein, for which the one or more tie cells have a fixed logic level.

Example 6 may include the device of example 5 and/or any other example disclosed herein, for which the one or more tie cells have a high logic level.

Example 7 may include the device of example 5 and/or any other example disclosed herein, for which the one or more tie cells have a low logic level.

Example 8 may include the device of example 1 and/or any other example disclosed herein, for which the one or more functional cells are one or more of a AND, OR, XOR, NOT, NAND, NOR and XNOR cell.

Example 9 may include the device of example 1 and/or any other example disclosed herein, for which a focused-ion beam device may be configured to edit errors in the integrated circuit through the focused-ion beam access point.

Example 10 may include the device of example 9 and/or any other example disclosed herein, for which the focused-ion beam device may be configured to edit errors in the integrated circuit with a focused ion beam to etch, cut or deposit material on the integrated circuit.

Example 11 may include a method of forming a semiconductor device comprising including providing a device layer comprising an integrated circuit, wherein the device layer is between a top metal layer and a bottom metal layer; providing a focused-ion beam access point on the top metal layer; connecting one or more tie cells to the integrated circuit of the device layer; and connecting one or more functional cells to the one or more tie cells, wherein the one or more tie cells and one or more function cells provide an electrical route on the top metal layer to the focused-ion beam access point.

Example 12 may include the method of example 11 and/or any other example disclosed herein, for which the electrical route on the top metal layer is configured for focused-ion beam editing of the device layer through the focused-ion beam access point.

Example 13 may include the method of example 11 and/or any other example disclosed herein, for which the one or more tie cells is a single tie cell, and the one or more functional cells is a plurality of functional cells, and wherein the single tie cell is connected to the plurality of functional cells.

Example 14 may include the method of example 11 and/or any other example disclosed herein, for which the one or more tie cells is a single tie cell, and the one or more functional cells is a single functional cell, and wherein the single tie cell is connected to the single functional cell.

Example 15 may include the method of example 11 and/or any other example disclosed herein, for which the one or more tie cells have a fixed logic level.

Example 16 may include the method of example 15 and/or any other example disclosed herein, for which the one or more tie cells have a high logic level.

Example 17 may include the method of example 15 and/or any other example disclosed herein, for which the one or more tie cells have a low logic level.

Example 18 may include the method of example 11 and/or any other example disclosed herein, for which the one or more functional cells are one or more of a AND, OR, XOR, NOT, NAND, NOR and XNOR cell.

Example 19 may include the method of example 11 and/or any other example disclosed herein, for which a focused-ion beam device is configured to edit errors in the integrated circuit through the focused-ion beam access point,

Example 20 may include the method of example 19 and/or any other example disclosed herein, for which the focused-ion beam device is configured to edit errors in the integrated circuit with a focused ion beam to etch, cut or deposit material on the integrated circuit.

These and other advantages and features of the aspects herein disclosed will be apparent through reference to the following description and the accompanying drawings. Furthermore, it is to be understood that the features of the various aspects described herein are not mutually exclusive and can exist in various combinations and permutations.

It will be understood that any property described herein for a specific system or device may also hold for any system or device described herein. It will also be understood that any property described herein for a specific method may hold for any of the methods described herein. Furthermore, it will be understood that for any device, system, or method described herein, not necessarily all the components or operations described will be enclosed in the device, system, or method, but only some (but not all) components or operations may be enclosed.

The term "comprising" shall be understood to have a broad meaning similar to the term "including" and will be understood to imply the inclusion of a stated integer or operation or group of integers or operations but not the exclusion of any other integer or operation or group of integers or operations. This definition also applies to variations on the term "comprising" such as "comprise" and "comprises".

The term "coupled" (or "connected") herein may be understood as electrically coupled or as mechanically coupled, e.g., attached or fixed or attached, or just in contact without any fixation, and it will be understood that both direct coupling or indirect coupling (in other words: coupling without direct contact) may be provided.

While the present disclosure has been particularly shown and described with reference to specific aspects, it should be understood by those skilled in the art that various changes in form and detail may be made therein without departing from the scope of the present disclosure as defined by the appended claims. The scope of the present disclosure is thus indicated by the appended claims and all changes which come within the meaning and range of equivalency of the claims are therefore intended to be embraced.

## Claims

1. A semiconductor device for backside power delivery comprising:
a device layer comprising an integrated circuit, wherein the device layer is between a top metal layer and a bottom metal layer;
a focused-ion beam access point on the top metal layer;
one or more tie cells connected to the integrated circuit of the device layer;
one or more functional cells connected to the one or more tie cells, wherein the one or more tie cells and one or more function cells provide an electrical route on the top metal layer to the focused-ion beam access point.

2. The semiconductor device of claim 1,
wherein the electrical route on the top metal layer is configured for focused-ion beam editing of the device layer through the focused-ion beam access point.

3. The semiconductor device of any one of claims 1 or 2,
wherein the one or more tie cells is a single tie cell, and the one or more functional cells is a plurality of functional cells, and wherein the single tie cell is connected to the plurality of functional cells.

4. The semiconductor device of any one of claims 1 to 3,
wherein the one or more tie cells is a single tie cell, and the one or more functional cells is a single functional cell, and wherein the single tie cell is connected to the single functional cell.

5. The semiconductor device of any one of claims 1 to 4,
wherein the one or more tie cells have a fixed logic level;
preferably wherein the one or more tie cells have a high logic level; and/or preferably wherein the one or more tie cells have a low logic level.

6. The semiconductor device of any one of claims 1 to 5,
wherein the one or more functional cells are one or more of a AND, OR, XOR, NOT, NAND, NOR and XNOR cell.

7. The semiconductor device of any one of claims 1 to 6,
wherein a focused-ion beam device may be configured to edit errors in the integrated circuit through the focused-ion beam access point;
preferably wherein the focused-ion beam device may be configured to edit errors in the integrated circuit with a focused ion beam to etch, cut or deposit material on the integrated circuit.

8. A method of forming a semiconductor device comprising:
providing a device layer comprising an integrated circuit, wherein the device layer is between a top metal layer and a bottom metal layer;
providing a focused-ion beam access point on the top metal layer;
connecting one or more tie cells to the integrated circuit of the device layer; and
connecting one or more functional cells to the one or more tie cells, wherein the one or more tie cells and one or more function cells provide an electrical route on the top metal layer to the focused-ion beam access point.

9. The method of claim 8,
wherein the electrical route on the top metal layer is configured for focused-ion beam editing of the device layer through the focused-ion beam access point.

10. The method of any one of claims 8 or 9,
wherein the one or more tie cells is a single tie cell, and the one or more functional cells is a plurality of functional cells, and wherein the single tie cell is connected to the plurality of functional cells.

11. The method of any one of claims 8 to 10,
wherein the one or more tie cells is a single tie cell, and the one or more functional cells is a single functional cell, and wherein the single tie cell is connected to the single functional cell.

12. The method of any one of claims 8 to 11,
wherein the one or more tie cells have a fixed logic level;
preferably wherein the one or more tie cells have a high logic level; and/or
preferably wherein the one or more tie cells have a low logic level.

13. The method of any one of claims 8 to 12,
wherein the one or more functional cells are one or more of a AND, OR, XOR, NOT, NAND, NOR and XNOR cell.

14. The method of any one of claims 8 to 13,
wherein a focused-ion beam device is configured to edit errors in the integrated circuit through the focused-ion beam access point.

15. The method of claim 14,
wherein the focused-ion beam device is configured to edit errors in the integrated circuit with a focused ion beam to etch, cut or deposit material on the integrated circuit.
